# FASCICULE DE BREVET EUROPEEN

(11) **EP 1 741 670 B1**
(45) Date de publication et mention de la délivrance du brevet: **06.06.2012**
(21) Numéro de dépôt: 06116644.3
(22) Date de dépôt: 05.07.2006
(51) Int. Cl.: B81B 1/00, B81C 1/00, G01N 33/50, C12N 15/82, G01N 33/483

(54) **Dispositif comportant un champ de pointes utilisé dans des applications biotechnologiques**
Einen Spitzenbereich umfassende Vorrichtung, die in biotechnologischen Anwendungen eingesetzt wird
Device incorporating a field of dots used in biotechnology applications

(30) Priorité: 05.07.2005 FR 0552044
(43) Date de publication de la demande: 10.01.2007
(73) Titulaire: STMicroelectronics S.A., 38926 Crolles cedex (FR)
(72) Inventeur: De Sagazan, Olivier, 35000, RENNES (FR); Denoual, Matthieu, 14000 Caen (FR)
(74) Mandataire: de Beaumont, Michel

(56) Documents cités:
- US-A- 4 383 885
- US-A- 4 969 468
- US-A- 5 304 775
- US-A- 5 457 041
- US-A1- 2004 060 902

## Description

### Domaine de l'invention

La présente invention concerne un procédé de fabrication d'un dispositif comportant un champ de pointes micrométriques. De tels dispositifs sont utilisés lors d'expériences biotechnologiques comme support de culture, d'analyse ou de manipulation de cellules biologiques.

### Exposé de l'art antérieur

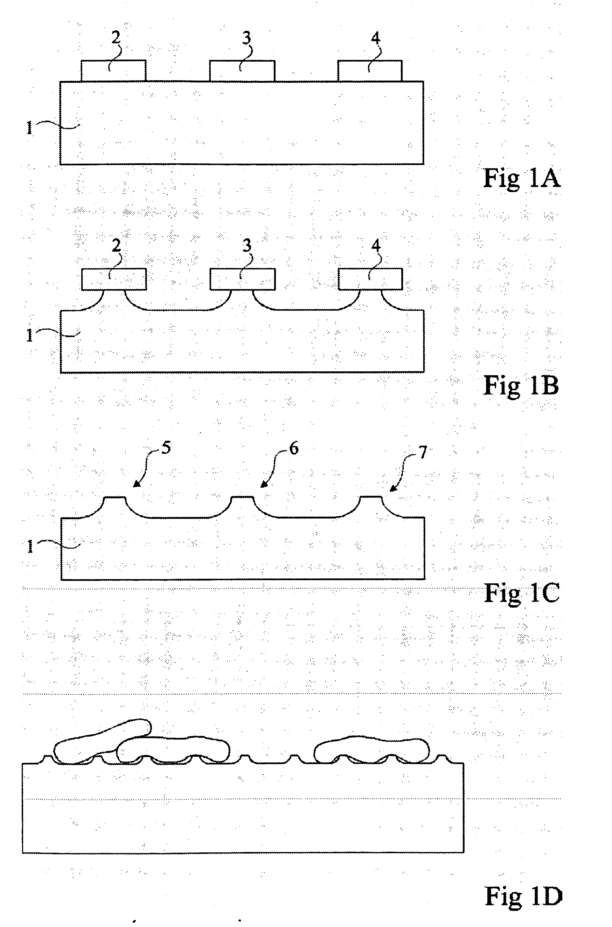

Les figures 1A à 1D sont des vues en coupe de structures obtenues lors d'étapes successives d'un procédé connu de fabrication d'un dispositif comportant un champ de pointes micrométriques.

Dans une étape initiale, illustrée en figure 1A, on forme, sur un substrat 1, un masque de gravure constitué d'un ensemble de blocs 1, 2 et 3 espacés les uns des autres et agencés matriciellement. Le substrat est par exemple une plaque de silicium et le masque de gravure est constitué de résine ou d'une couche d'oxyde de silicium.

Dans une étape suivante, illustrée en figure 1B, on effectue une gravure isotrope de la partie supérieure du substrat 1. Les zones du substrat 1 non recouvertes par les blocs 2, 3, 4 sont gravées ainsi que les parties latérales des zones recouvertes par les blocs 2, 3 et 4 qui sont situées à proximité des zones découvertes. Le temps de gravure est prévu pour que la gravure "horizontale" sous les blocs 2, 3, 4 soit arrêtée lorsqu'il ne reste plus que des petites portions de substrat non gravées sous les blocs 2, 3 et 4. Toutefois, afin d'assurer le maintien des blocs 2, 3 et 4, c'est-à-dire pour éviter qu'ils ne tombent, les portions de substrat restantes doivent être suffisamment larges.

Dans une étape suivante, illustrée en figure 1C, on élimine les blocs 2, 3 et 4 du masque de gravure. On obtient ainsi un champ de pointes "tronquées" 5, 6 et 7 en surface du substrat 1. La hauteur des pointes est de un ou quelques microns et la distance inter-pointes au moins six fois supérieure à la hauteur des pointes tronquées. La densité de pointes est alors de 1 à 2 pointes sur une surface de 100 µm².

La figure 1D est une vue en coupe d'une partie d'un dispositif comportant un champ de pointes obtenu selon le procédé précédemment décrit et sur lequel sont placées des cellules biologiques. Le diamètre moyen d'une cellule biologique étant de 15 µm, chaque cellule est posée sur quelques pointes du dispositif, entre 3/4 pointes et une dizaine selon la forme de la cellule.

Les documents US-A-2004/0060902 et US-A-4969468 décrient les procédés alternatives pour fabriquer les étalages de pointes micrométriques. En outre, divers procédés de gravure anisotrope pour le réalisation des plaquettes de silicium micro-structurés sont connus par les documents US-A-5304775 et US-A-4383885.

Un inconvénient d'un tel dispositif est qu'il comprend des pointes de faible hauteur et de surcroît tronquées, c'est-à-dire non pointues. De telles pointes ne peuvent être utilisées pour effectuer des opérations de transfection consistant à percer les cellules vivantes pour y introduire des éléments, tels que des virus, préalablement posés sur les pointes.

### Résumé de l'invention

Un objet de la présente invention est de prévoir un procédé de fabrication d'un dispositif comportant un champ de pointes micrométriques présentant des pointes réellement pointues permettant d'effectuer des opérations de transfection.

Un autre objet de la présente invention est de prévoir un tel procédé qui soit facile à mettre en oeuvre.

Un autre objet de la présente invention est de prévoir un tel procédé qui permette d'obtenir un dispositif présentant une densité de pointes élevée.

Pour atteindre ces objets, la présente invention prévoit un procédé de fabrication d'un dispositif comportant un champ de pointes micrométriques selon le revendication 1.

Selon un mode de réalisation de la présente invention, lors de la gravure plasma, le débit gazeux du chlore est plus élevé que celui de l'hélium, le débit gazeux du chlore étant par exemple de 130 cm³/minute et le débit de l'hélium de 70 cm³/minute.

Selon un mode de réalisation de la présente invention, la couche polycristalline comprend du silicium.

Selon un mode de réalisation de la présente invention, le support est un substrat semiconducteur, tel qu'un substrat de silicium, recouvert d'une couche isolante, telle qu'une couche d'oxyde de silicium.

Selon un mode de réalisation de la présente invention, le procédé comprend, préalablement à l'étape de gravure plasma, un dépôt d'une couche de protection sur la couche polycristalline et la formation d'ouvertures traversantes dans la couche de protection, des pointes étant ensuite formées en surface de la couche polycristalline à l'intérieur desdites ouvertures.

Selon un mode de réalisation de la présente invention, le procédé comprend, préalablement à l'étape de gravure plasma, une gravure de la couche polycristalline de façon à former des blocs polycristallins, des pointes étant ensuite formées en surface des blocs polycristallins.

Selon un mode de réalisation de la présente invention, le procédé comprend en outre la formation selon un procédé de dépôt conforme de films conducteurs sur les pointes recouvrant les blocs polycristallins, chaque film conducteur recouvrant les pointes d'un bloc cristallin se prolongeant par une piste conductrice placée sur ledit support.

Selon un mode de réalisation de la présente invention, le diamètre sommital des pointes est au moins dix fois plus petit que la hauteur des pointes, le diamètre sommital des pointes étant par exemple de 100 nm et la hauteur des pointes de 10 µm, et la densité de pointes est supérieure à 10 pointes sur une surface de 100 µm².

La présente invention prévoit aussi un dispositif comportant au moins un champ de pointes micrométriques formées en surface d'un bloc polycristallin contenant du silicium placé sur un support, chaque champ de pointes étant recouvert d'un film conducteur se prolongeant par une piste conductrice placée en surface du support et s'étendant jusqu'à une borne de contact.

Selon un mode de réalisation de la présente invention, le dispositif comprend une multitude de champs de pointes formés sur des blocs cristallins agencés en forme de matrice.

Selon un aspect de la présente invention, le dispositif est utilisé pour évaluer l'activité de cellules biologiques placées sur les champs de pointes du dispositif, un appareil de mesure étant relié aux bornes de contact.

### Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
Les figures 1A à 1D sont des vues en coupe de structures obtenues à l'issue d'étapes successives d'un procédé, précédemment décrit, de fabrication d'un dispositif comportant un champ de pointes micrométriques ;
la figure 2 est un schéma d'un appareillage de gravure dans lequel est mise en oeuvre une partie du procédé de fabrication selon la présente invention ;
les figures 3A et 3B sont des vues en coupe d'exemples de dispositifs obtenus à l'issue du procédé de fabrication selon la présente invention ;
la figure 3C est une vue en coupe d'une petite partie du champ de pointes d'un dispositif obtenu selon le procédé de la présente invention sur lequel est placée une cellule biologique ;
les figures 4A à 4D sont des vues en coupe ou en perspective de structures obtenues à l'issue d'étapes successives d'un procédé exemplaire ; et
les figures 5A à 5D sont des vues en coupe ou en perspective de structures obtenues à l'issue d'étapes successives d'un autre mode de mise en oeuvre du procédé selon la présente invention.

### Description détaillée

Par souci de clarté, de mêmes éléments ont été désignés par de mêmes références aux différentes figures. De plus, les diverses figures ne sont pas tracées à l'échelle.

Le procédé de la présente invention permet de former un champ de pointes en surface d'une couche polycristalline selon un procédé de gravure spécifique permettant d'obtenir une multitude de pointes en surface de la couche polycristalline.

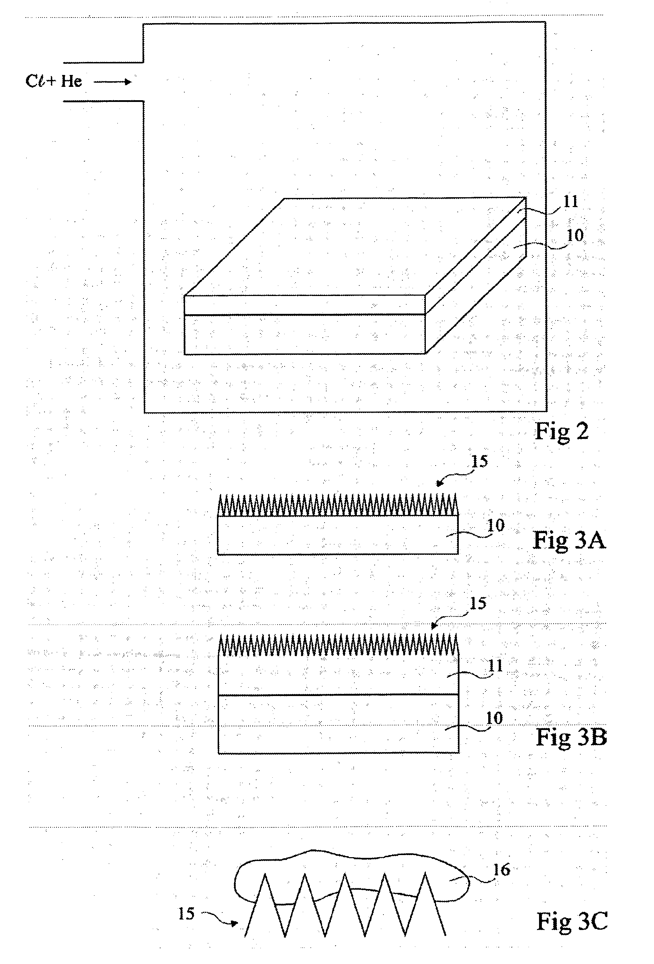

La figure 2 est un schéma illustrant un appareillage de gravure dans lequel est placée une plaque support 10 recouverte d'une couche polycristalline 11. Cet appareillage permet d'effectuer une gravure plasma anisotrope de la couche polycristalline 11.

Selon un aspect de la présente invention, le plasma gazeux utilisé pour graver la couche polycristalline 11 contient du chlore et d'hélium. Le mélange gazeux peut éventuellement contenir d'autres éléments neutres ou catalyseurs.

Les figures 3A et 3B sont des vues en coupe d'exemples de dispositifs comportant un champ de pointes 15 obtenu selon le procédé précédemment décrit. La hauteur des pointes est sensiblement proportionnelle à la durée de gravure, ou à tout le moins augmente en fonction de cette dernière. Selon que la couche cristalline 11 est mince ou épaisse, les pointes sont formées sur toute l'épaisseur de la couche cristalline ou dans la partie supérieure de celle-ci comme cela est visible respectivement en figures 3A et 3B.

Selon le procédé de la présente invention, il est possible de fabriquer de "grandes" pointes ayant une hauteur de 10 µm ou plus. De plus, les pointes obtenues sont "pointues" et présentent à leur extrémité un diamètre inférieur à 100 nm.

On notera par ailleurs que les pointes obtenues sont très proches les unes des autres. On a donc une forte densité de pointes. Pour des pointes d'environ 10 µm de haut, la densité est de plusieurs dizaines de pointes, 30 ou 40, pour une surface de 100 µm².

La figure 3C est une vue en coupe agrandie des pointes d'un dispositif obtenu selon le procédé de la présente invention, sur lesquelles est placée une cellule biologique 16. En raison de la finesse des pointes 15 et de leur densité, il est possible de "percer" la cellule en de nombreux endroits. De plus, les pointes peuvent s'enfoncer profondément et atteindre le coeur de la cellule.

Ainsi, un dispositif obtenu selon le procédé de la présente invention permet de réaliser des opérations de transfection. Pour ce faire, les éléments que l'on souhaite introduire dans des cellules sont déposés sur le champ de pointes 15 préalablement au placement des cellules sur les pointes. Etant donné la finesse des pointes et leur densité, la membrane externe des cellules ne résiste pas et se perce. L'introduction des pointes dans les cellules permet de faire entrer des éléments recouvrant les pointes au coeur des cellules "empalées".

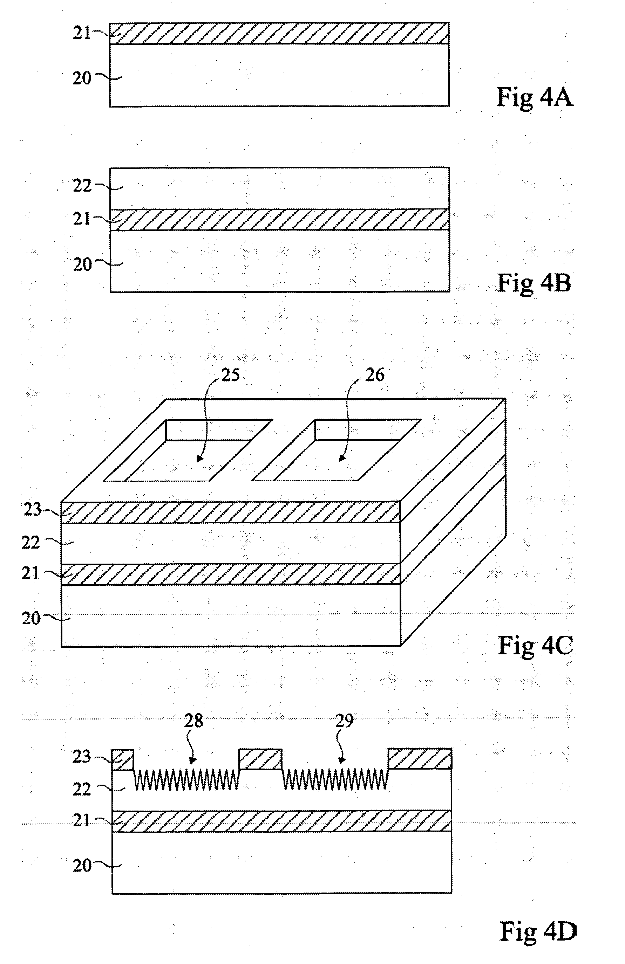

Un exemple détaillé est décrit ci-après en relation avec les figures 4A à 4D.

Dans une étape initiale, on forme sur un substrat 20, une couche isolante 21. Le substrat 20 peut être une plaque de silicium et la couche isolante 21 une couche d'oxyde de silicium ayant par exemple une épaisseur de 500 nm.

A l'étape suivante illustrée en figure 4B, on forme une couche polycristalline 22 sur la couche isolante 21. Pour ce faire, on peut former l'ensemble de la couche polycristalline selon un procédé de dépôt chimique en phase vapeur. On peut aussi former une fine couche d'accroche par dépôt chimique en phase vapeur puis faire croître le reste de la couche dans un four d'épitaxie. La couche polycristalline 22 peut être une couche de silicium ou de silicium/germanium. L'épaisseur de la couche polycristalline 22 est choisie en fonction de la hauteur des pointes que l'on souhaite former ultérieurement, l'épaisseur de la couche polycristalline devant naturellement être au moins égale à la hauteur souhaitée des pointes. On prévoira de préférence une couche polycristalline présentant une épaisseur supérieure à la hauteur des pointes souhaitées de façon que les pointes soient "ancrées" dans la partie inférieure, non gravée de la couche polycristalline.

Dans une étape suivante, illustrée en figure 4C, on dépose une couche protectrice 23 sur la couche polycristalline 22. On forme ensuite des ouvertures traversantes 25 et 26 dans la couche protectrice 23, par exemple selon un procédé de gravure humide à base de HF. La couche protectrice 23 peut être une couche d'oxyde de silicium obtenue par oxydation thermique de la couche polycristalline 22 en silicium ou silicium/germanium. L'épaisseur de la couche protectrice 23 est par exemple de 500 nm.

A l'étape suivante, illustrée en figure 4D, on effectue une gravure plasma anisotrope des zones découvertes de la couche polycristalline 22, à l'intérieur des ouvertures 25 et 26. Pour ce faire, on utilise un mélange gazeux comprenant du chlore et de l'hélium. On obtient alors des champs de pointes 28 et 29 dans chacune des ouvertures 25 et 26 dans la partie supérieure de la couche polycritalline 22.

Dans le cas d'une couche polycristalline 22 constituée de silicium, et d'une couche protectrice 23 constituée d'oxyde de silicium, il est possible d'obtenir des pointes de l'ordre de 10 µm de hauteur en effectuant une gravure plasma anisotrope présentant les caractéristiques suivantes. Le débit gazeux du chlore est de 130 cm³ par minute et le débit gazeux de l'hélium de 70 cm³ par minute. La pression des gaz est de 4000 mT. La durée de gravure est comprise entre 10 et 20 minutes. La puissance utilisée pour un appareillage du type LAM 490 est de 300 watts, la distance entre électrodes étant de 0,5 cm.

Bien que deux ouvertures 25 et 26 soient représentées en figure 4D, le dispositif formé selon le procédé susmentionné peut comprendre une multitude d'ouvertures agencées par exemple matriciellement. Un tel dispositif permet de placer dans les ouvertures divers types de cellules biologiques ou divers types d'éléments à introduire dans les cellules par transfection. Ceci permet d'effectuer divers types d'analyses.

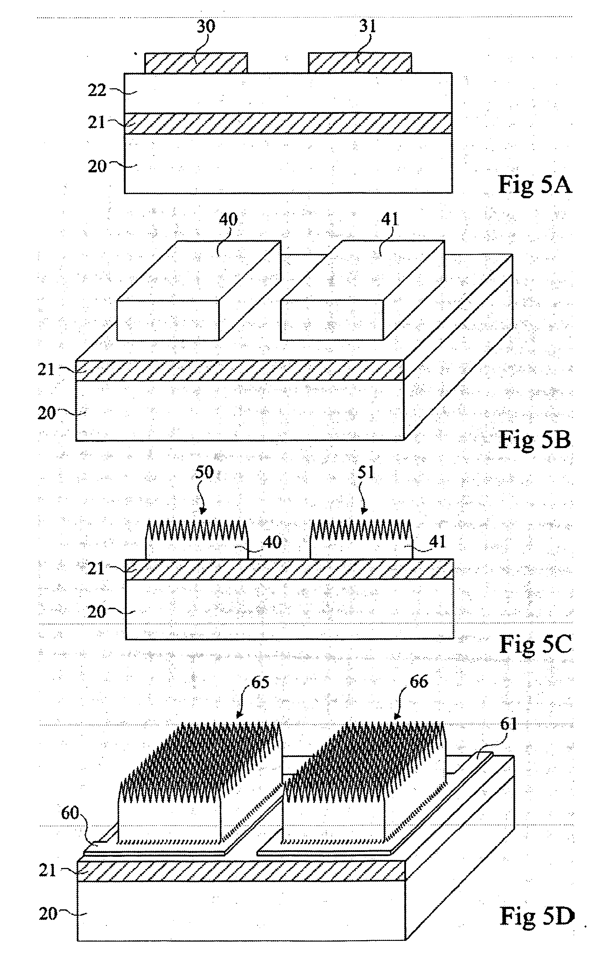

Un exemple de mise en oeuvre de la présente invention est décrit ci-après en relation aux figures 5A à 5D.

Dans une étape initiale, représentée en figure 5A, on dépose un masque de gravure sur une structure telle que celle illustrée en figure 4B et comprenant un empilement d'un substrat 20, d'une couche isolante 21 et d'une couche polycristalline 22. Le masque de gravure comprend un ensemble de blocs protecteurs 30 et 31 placés sur la couche polycristalline 22.

A l'étape suivante, illustrée en figure 5B, on effectue une gravure anisotrope de la couche polycritalline 22 selon un procédé standard permettant d'obtenir des blocs polycristallins 40 et 41 placés sous les blocs protecteurs 30 et 31. On élimine ensuite le masque de gravure, c'est-à-dire les blocs protecteurs 30 et 31.

A l'étape suivante, illustrée en figure 5C, on effectue une gravure plasma anisotrope des blocs polycristallins 40 et 41 en utilisant un mélange gazeux de chlore et d'hélium. On obtient alors des champs de pointes 50 et 51 formés dans la partie supérieure des blocs polycristallins 40 et 41.

A l'étape suivante, illustrée en figure 5D, on dépose une fine couche conductrice, par exemple en or, sur l'ensemble de la structure précédemment obtenue. On grave ensuite cette fine couche conductrice de façon à l'éliminer entre les blocs polycristallins 40 et 41 sauf en certains endroits préalablement définis de façon à former des pistes conductrices 60 et 61 sur la couche isolante 21. Les blocs polycristallins 40, 41 et les champs de pointes 50, 51 sont alors recouverts de films conducteurs 65, 66 reliés aux pistes conductrices 60, 61. Les pistes conductrices 60 et 61 relient les films conducteurs 65, 66 recouvrant les champs de pointes 50 et 51 à des bornes de contact placées par exemple en périphérie du substrat 20.

Bien que deux blocs polycristallins 40 et 41 soient représentés en figure 5D, le dispositif formé selon le procédé susmentionné peut comprendre une multitude de blocs polycristallins agencés par exemple matriciellement. De nombreuses bornes de contact sont alors prévues et placées par exemple en périphérie de la plaque. Ces bornes de contact sont reliées aux champs de pointes formés en surface des blocs polycristallins au moyen de multiples pistes conductrices placées sur la couche isolante 21.

Un exemple d'utilisation d'un tel dispositif est le suivant. Les bornes de contact sont reliées électriquement à un appareil de mesure. Ceci permet d'évaluer l'activité de cellules biologiques placées sur les champs de pointes en mesurant par exemple des valeurs de potentiels ou de courants électriques.

La surface des blocs polycristallins du dispositif peut être de taille identique ou inférieure à celle d'une cellule biologique. Le dispositif ainsi obtenu permet d'analyser un "tissu" de cellules biologiques, tel qu'un morceau de peau, en plaçant ce dispositif contre le tissu. Il est alors possible d'analyser l'activité des diverses cellules du tissu. On pourra par exemple analyser l'activité de cellules telles que des neurones d'un réseau de neurones.

Bien entendu, la présente invention est susceptible de diverses variantes et modifications qui apparaîtront à l'homme de l'art. En particulier, l'homme de l'art pourra imaginer d'autres formes de dispositifs pouvant être obtenus selon le procédé de la présente invention.

## Revendications

1. Procédé de fabrication d'un dispositif comportant un champ de pointes micrométriques comprenant une étape de
formation d'une couche polycristalline (11) comprenant du silicium sur un support (10) ;
**caractérisé en ce qu'**il comprend l'étape consistant à effectuer une gravure plasma anisotrope sans masquage de tout ou partie de la couche polycristalline en utilisant un mélange gazeux comprenant du chlore et de l'hélium, d'où il résulte que des pointes (15) sont formées en surface de la couche polycristalline.

2. Procédé selon la revendication 1, dans lequel lors de la gravure plasma, le débit gazeux du chlore est plus élevé que celui de l'hélium, le débit gazeux du chlore étant par exemple de 130 cm³/minute et le débit de l'hélium de 70 cm³/minute.

3. Procédé selon la revendication 1, dans lequel le support est un substrat semiconducteur (20), tel qu'un substrat de silicium, recouvert d'une couche isolante (21), telle qu'une couche d'oxyde de silicium.

4. Procédé selon la revendication 1, comprenant préalablement à l'étape de gravure plasma, un dépôt d'une couche de protection (23) sur la couche polycristalline (22) et la formation d'ouvertures (25, 26) traversantes dans la couche de protection, des pointes (28, 29) étant ensuite formées en surface de la couche polycristalline à l'intérieur desdites ouvertures.

5. Procédé selon la revendication 1, comprenant préalablement à l'étape de gravure plasma, une gravure de la couche polycristalline (22) de façon à former des blocs polycristallins (40, 41), des pointes (50, 51) étant ensuite formées en surface des blocs polycristallins.

6. Procédé selon la revendication 5, comprenant en outre la formation selon un procédé de dépôt conforme de films conducteurs (65, 66) sur les pointes (50, 51) recouvrant les blocs polycristallins (40, 41), chaque film conducteur recouvrant les pointes d'un bloc cristallin se prolongeant par une piste conductrice (60, 61) placée sur ledit support (20, 21).

7. Procédé selon la revendication 1, dans lequel le diamètre sommital des pointes est au moins dix fois plus petit que la hauteur des pointes, le diamètre sommital des pointes étant par exemple de 100 nm et la hauteur des pointes de 10 µm, et dans lequel la densité de pointes est supérieur à 10 pointes sur une surface de 100 µm².

8. Dispositif comportant au moins un champ de pointes micrométriques (50, 51) fabriqué selon l'un quelconque des procédés des revendications 1 à 8, le champ de pointes micrométriques étant formé en surface d'un bloc polycristallin (40, 41) contenant du silicium placé sur un support (20, 21), chaque champ de pointes étant recouvert d'un film conducteur (65, 66) se prolongeant par une piste conductrice (60, 61) placée en surface du support et s'étendant jusqu'à une borne de contact.

9. Dispositif selon la revendication 8 comprenant une multitude de champs de pointes (50, 51) formés sur des blocs polycristallins (40, 41) agencés en forme de matrice.

10. Utilisation d'un dispositif selon la revendication 8 pour évaluer l'activité de cellules biologiques placées sur les champs de pointes (50, 51) du dispositif, un appareil de mesure étant reliée aux bornes de contact.

## Claims

1. A method for manufacturing a device comprising a field of micrometric tips, comprising one step of forming a polycrystalline layer (11) comprising silicon on a support (10);
**characterized in that** it comprises the step of performing an anisotropic plasma etching, without masking, of all or part of the polycrystalline layer by using a gas mixture comprising chlorine and helium, whereby tips (15) are formed at the surface of the polycrystalline layer.

2. The method of claim 1, wherein in the plasma etching, the gas flow rate of chlorine is higher than that of helium, the gas flow rate of helium for example being 130 cm³/minute and the helium flow rate being 70 cm³/minute.

3. The method of claim 1, wherein the support is a semiconductor substrate (20), such as a silicon substrate, covered with an insulating layer (21), such as a silicon oxide layer.

4. The method of claim 1, comprising, prior to the plasma etch step, a deposition of a protection layer (23) on the polycrystalline layer (22) and the forming of through openings (25, 26) in the protection layer, tips (28, 29) being then formed at the surface of the polycrystalline layer inside of said openings.

5. The method of claim 1, comprising, prior to the plasma etch step, an etching of the polycrystalline layer (22) to form polycrystalline blocks (40, 41), tips (50, 51) being then formed at the surface of the polycrystalline blocks.

6. The method of claim 5, further comprising the forming according to a conformal deposition method of conductive films (65, 66) on the tips (50, 51) covering the polycrystalline blocks (40, 41), each conductive film covering the tips of a crystal block extending in a conductive track (60, 61) placed on said support (20, 21).

7. The method of claim 1, wherein the top diameter of the tips is at least ten times smaller than the tip height, the top diameter of the tips for example being 100 nm and the height of the tips for example being 10 µm, and wherein the tip density is greater than 10 tips on a 100 µm² surface area.

8. A device comprising at least one field of micrometric tips (50, 51) manufactured according to any of claims 1 to 7, formed at the surface of a polycrystalline block comprising silicon (40, 41) placed on a support (20, 21), each tip field being covered with a conductive film (65, 66) extending in a conductive track (60, 61) placed at the surface of the support and extending to reach a contact terminal.

9. The device of claim 8, comprising a multitude of tip fields (50, 51) formed on crystal blocks (40, 41) arranged in a matrix.

10. The use of the device of claim 8 to evaluate the activity of biological cells placed on the tip fields (50, 51) of the device, a measurement device being connected to the contact terminals.

## Patentansprüche

1. Ein Verfahren zur Herstellung einer ein Feld mikrometrischer Spitzen aufweisenden Vorrichtung, wobei Folgendes vorgesehen ist: ein Schritt des Formens einer polykristallinen Schicht (11), die Silizium auf einem Träger (10) aufweist;
**dadurch gekennzeichnet, dass** Folgendes vorgesehen ist:
der Schritt des Ausführens einer anisotropischen Plasmaätzung ohne Maskierung der ganzen oder eines Teils der polykristallinen Schicht unter Verwendung einer Gasmischung, die Chlor und Helium aufweist, wodurch Spitzen (15) an der Oberfläche der polykristallinen Schicht gebildet werden.

2. Verfahren nach Anspruch 1, wobei beim Plasmaätzen die Gasströmungsrate des Chlors höher liegt als die des Heliums, wobei die Gasströmungsrate des Heliums beispielsweise 130 cm³/Minute und die Heliumströmungsrate 70 cm³/Minute beträgt.

3. Verfahren nach Anspruch 1, wobei der Träger ein Halbleitersubstrat (20) ist, beispielsweise ein Siliziumsubstrat und zwar abgedeckt mit einer Isolierschicht (21), beispielsweise einer Siliziumoxidschicht.

4. Verfahren nach Anspruch 1, wobei vor dem Plasmaätzschritt eine Abscheidung einer Schutzschicht (23) auf der polykristallinen Schicht (22) und die Formung durch Öffnungen (25, 26) in der Schutzschicht erfolgt, wobei Spitzen (28, 29) dann an der Oberfläche der polykristallinen Schicht innerhalb der erwähnten Öffnungen geformt werden.

5. Verfahren nach Anspruch 1, wobei vor dem Plasmaätzschritt eine Ätzung der polykristallinen Schicht (22) vorgesehen ist zur Bildung von polykristallinen Blöcken (40, 41), wobei Spitzen (50, 51) sodann an der Oberfläche der polykristallinen Blöcke geformt werden.

6. Verfahren nach Anspruch 5, wobei ferner die Formung gemäß einer konformen Abscheidungsmethode von leitenden Filmen oder Schichten (65, 66) auf den Spitzen (50, 51) vorgesehen ist und zwar die polykristallinen Blöcke (40, 41) abdeckend, wobei jede leitende Schicht, die die Spitzen eines Kristallblocks abdeckt, sich in einer leitenden Bahn (60, 61), platziert auf dem Träger (20, 21), erstreckt.

7. Verfahren nach Anspruch 1, wobei der obere Durchmesser der Spitzen mindestens zehn Mal kleiner ist als die Spitzenhöhe, wobei der obere Durchmesser der Spitzen beispielsweise 100 nm ist und die Höhe der Spitzen beispielsweise 10 µm ist, und wobei schließlich die Spitzendichte größer als 10 Spitzen auf einem 100 µm² Oberflächengebiet ist.

8. Eine Vorrichtung, die mindestens ein Feld von mikrometrischen Spitzen (50, 51) aufweist, und zwar hergestellt gemäß einem der Ansprüche 1 bis 7, und zwar geformt an der Oberfläche eines polykristallinen Blocks, der Silizium (40, 41) platziert auf einem Träger (20, 21) aufweist, wobei jedes Spitzengebiet oder Spitzenfeld mit einer leitenden Schicht oder einem leitenden Film (65, 66) abgedeckt ist, der sich in einer leitenden Bahn oder Spur (60, 61), platziert an der Oberfläche des Trägers erstreckt und sich zur Erreichung eines Kontaktanschlusses erstreckt.

9. Vorrichtung nach Anspruch 8, wobei eine Vielzahl von Spitzenfeldern (50, 51) vorgesehen ist, und zwar ausgebildet auf Kristallblöcken (40, 41), angeordnet in einer Matrix.

10. Die Verwendung der Vorrichtung nach Anspruch 8 zur Auswertung der Aktivität biologischer Zellen, platziert auf den Spitzenfeldern (50, 51) der Vorrichtung, wobei eine Messvorrichtung mit den Kontaktanschlüssen verbunden ist.
